# EUROPEAN PATENT APPLICATION

(11) **EP 4 669 051 A1**
(43) Date of publication of application: **24.12.2025**
(21) Application number: 25182236.7
(22) Date of filing: 12.06.2025
(51) Int. Cl.: H10D 8/60, H10D 62/10, H10D 64/00, H10D 64/23, H10D 62/832

(54) **ELECTRONIC DEVICE BASED ON SIC HAVING IMPROVED ELECTRICAL PERFORMANCES AND MANUFACTURING METHOD**

(30) Priority: 19.06.2024 IT 202400014086
(71) Applicant: STMicroelectronics International N.V., 1228 Plan-les-Ouates, Geneva (CH)
(72) Inventor: RASCUNÀ, Simone, 95129 CATANIA (IT); PUGLISI, Valeria, 95125 CATANIA (IT); BELLOCCHI, Gabriele, 95124 CATANIA (IT)
(74) Representative: Studio Torta S.p.A.

(57) **Abstract**

An electronic device (50) has a semiconductor body (53) of silicon carbide which has a front surface (53a), a first conductivity type (N) and accommodates an active area (54) and an edge area (55) laterally to the active area along a first direction (X). A first termination doped region (62) extends from the front surface into the semiconductor body, at least in part into the edge area (55), wherein the first termination doped region has a second conductivity type (P) different from the first conductivity type. A first metal region (65) extends on the front surface, above the active area and the first termination doped region, wherein the first metal region has a first thickness and interrupts, along the first direction (X), above the first termination doped region. A second metal region (72) extends at a distance from the front surface above the edge area, laterally to the first metal region along the first direction (X). The second metal region has a second thickness smaller than the first thickness.

## Description

### Technical Field

The present invention relates to an electronic device based on SiC having improved electrical performances and to a manufacturing method of the electronic device.

### Background

Silicon carbide (SiC) is gaining considerable interest in the semiconductor industry, in particular for the manufacture of electronic components such as diodes or transistors, especially for power applications.

Electronic devices formed in a substrate of silicon carbide, in its different polytypes (for example, 3C-SiC, 4H-SiC, 6H-SiC), have numerous advantages such as low output resistance in conduction, low leakage current, resistance at high operating temperatures and high operating frequencies.

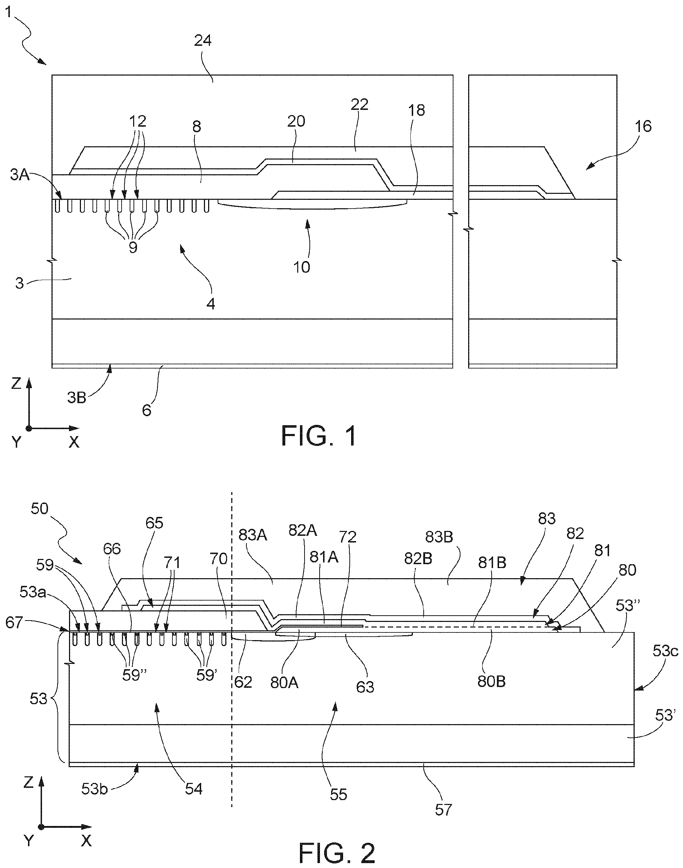

Figure 1 shows a cross-section, in a Cartesian (triaxial) reference system of axes X, Y, Z, of a portion of an electronic device (here exemplarily a JBS, "Junction Barrier Schottky", diode) 1 of a known type.

The JBS device 1 comprises a semiconductor body 3, of N-type SiC, having an upper surface 3a and a lower surface 3b. The semiconductor body 3 includes, for example, a substrate and one or more regions grown epitaxially on the substrate, of N-type and having respective doping concentration values.

The JBS device 1 also comprises multiple junction barrier elements 9 (hereinafter also referred to as JB, Junction-Barrier, elements 9) in the semiconductor body 3, facing the upper surface 3a and each including a respective implanted region in the semiconductor body 3, of P-type, and an ohmic contact (not shown) on the implanted region, at the level of the upper surface 3a of the semiconductor body 3.

The JBS device 1 further comprises a first metallization 8, which extends on the upper surface 3a, in electrical contact with the JB elements 9 through the respective ohmic contacts (not shown).

The JBS device 1 further comprises an edge termination region 10 (or protection ring), in particular a P-type implanted region, which completely surrounds the JB elements 9.

The edge termination region 10 has a doping level comprised between 10¹⁵ and 10¹⁸ atoms/cm³.

Schottky diodes 12 are formed at the interface between the first metallization 8 and the semiconductor body 3, where semiconductor-metal Schottky junctions are formed. The region of the JBS device 1 that includes the JB elements 9 and the Schottky diodes 12 (i.e., the region contained within the protection ring 10) is an active area 4 of the JBS device 1.

The JBS device 1 further comprises a second metallization 6, which extends onto the lower surface 3b. The first and the second metallizations 8, 6 form, respectively, anode and cathode electrical terminals, biasable during use of the JBS device 1.

An electrically passive region 16 extends externally to the edge termination region 10.

An insulating layer 18, in particular of silicon oxide (SiO₂), extends partially above the edge termination region 10.

The first metallization 8 is in electrical contact with a portion of the edge termination region 10, where the latter is not covered by the insulating layer 18, and also extends partially above the insulating layer 18.

The first metallization 8 has a same thickness both over the active area 4 (where it acts as an anode metallization) and over the insulating layer 18 (where it acts as a field plate region).

An interface layer 20, here of silicon nitride (SiN), extends above the first metallization 8 and the insulating layer 18.

Furthermore, the JBS device 1 comprises a passivation layer 22, in particular of polymide, which extends above the interface layer 20. In other words, the interface layer 20 acts as an interface between the passivation layer 22 and the underlying layers, here the first metallization 8 and the insulating layer 18.

A protection layer 24, of a resin such as for example Bakelite, here extends above the passivation layer 22, to protect the JBS device 1 and forms a package.

The interface layer 20 ensures good adhesion of the passivation layer 22, compared for example to the case in which the passivation layer 22 extends directly onto the upper surface 3a of the semiconductor body 3.

However, the Applicant has verified that some critical conditions of use or of thermal or thermo-mechanical test of the JBS device 1 may cause a delamination or partial detachment of the passivation layer 22 from the interface layer 20 due to the stress generated. This occurs, in particular, in the presence of high use temperatures (for example, above 150°C). This effect, in addition to making the JBS device 1 structurally fragile, may facilitate the onset of unwanted electric discharges which do not allow the JBS device 1 to operate correctly or completely compromise its functioning.

In fact, the Applicant has verified that in some process conditions of thermo-mechanical or mechanical stress following the assembling process, the interface layer 20 has one or more local cracks throughout the entire thickness which, at the first metallization 8, cause the generation of such electric discharges. This issue occurs, in particular, when the JBS device 1 is subject to high thermal excursions and high voltage differences under reverse bias conditions.

The need is therefore felt to overcome the aforementioned issues.

### Summary

According to the present invention, an electronic device based on SiC and a manufacturing method thereof are provided, as defined in the attached claims.

### Brief Description of the Drawings

For a better understanding of the present invention, embodiments are now described, purely by way of non-limiting example, with reference to the attached drawings, wherein:
- Figure 1 illustrates, in cross-sectional view, an electronic device of a known type;
- Figure 2 illustrates, in cross-sectional view, an electronic device according to one embodiment; and
- Figures 3A-3F show, in cross-sectional view, manufacturing steps of the electronic device of Figure 2, according to one embodiment.

### Description of Embodiments

Figure 2 shows an electronic device 50. The electronic device 50 is a Schottky diode, in particular of the JBS-type; however, the present description is not limited to this device and also finds application to other types of electronic devices, in particular Schottky diodes of different type (for example of the MPS-type), or even to other electronic devices such as for example MOSFET, IGBT, PN diode, PiN diode, etc., in particular of the vertical-conduction type for power applications.

In particular, Figure 2 shows, in a Cartesian reference system XYZ having orthogonal axes X, Y, Z, an end portion of the electronic device 50 arranged peripherally to a die of semiconductor material wherein the electronic device 50 is integrated.

The device 50 comprises a semiconductor body 53, having a front surface 53a and a rear surface 53b at a distance from each other along the Z axis.

The semiconductor body 53 also comprises a lateral surface 53c transversal, in particular substantially orthogonal, to the front surface 53a.

In detail, the lateral surface 53c laterally delimits at one end, along the X axis, the semiconductor body 53.

The lateral surface 53c may for example be formed following a step of dicing a wafer of semiconductor material, during a manufacturing process of the electronic device 50.

The semiconductor body 53 is of N-type or P-type silicon carbide (SiC) (hereinafter non-limiting reference will be made to the sole N-type). In particular, the semiconductor body 53 is of 4H-SiC type, however other polytypes may be used, such as 2H-SiC, 3C-SiC and 6H-SiC.

In the embodiment of Figure 2, the semiconductor body 53 includes a substrate 53' and a drift region 53" which extends onto the substrate 53' and is formed for example by one or more epitaxial layers grown on the substrate 53'.

For example, the substrate 53' may have an N-type dopant concentration comprised between 1·10¹⁸ atoms/cm³ and 1·10²² atoms/cm³ and has a thickness, measured along the Z axis, comprised for example between 100 µm and 450 µm and, in particular, equal to about 360 µm. The drift region 53" may have a dopant concentration smaller than the dopant concentration of the substrate 53' and a thickness along the Z axis comprised, for example, between 5 and 20 µm.

The semiconductor body 53 comprises an active area 54 and an edge area 55 that extends laterally to the active area 54 along the X axis, in particular monolithic to the active area 54.

In Figure 2, for illustrative clarity, a dashed line parallel to the Z axis separates, in a purely indicative and non-limiting manner, the active area 54 from the edge area 55.

The edge area 55 may extend around the active area 54, surrounding the active area 54.

In particular, in the embodiment of Figure 2, the edge area 55 may extend along the X axis up to the lateral surface 53c of the semiconductor body 53.

A metallization 57, in this example forming a cathode metallization, for example of Ti/NiV/Ag or Ti/NiV/Au extends onto the rear surface 53b. The metallization 57 may also comprise an ohmic contact layer (for example of nickel silicide or titanium) that extends in contact with the rear surface 53b.

A plurality of barrier doped regions 59', of conductivity opposite to the semiconductor body 53, i.e. here of P-type, extend into the semiconductor body 53 (in particular in the drift region 53"), starting from the front surface 53a, at a distance from each other along the X axis.

The barrier doped regions 59' may have a width, along the X axis, for example comprised between 0.5 µm and 10 µm.

In this embodiment, the electronic device 50 comprises, optionally, for each barrier doped region 59', also a respective ohmic contact region 59", accommodated in the barrier doped region 59' at the front surface 53a.

Each doped region 59' and the respective ohmic contact region 59" form a junction-barrier element 59, hereinafter also referred to as JB (Junction-Barrier) element 59.

In embodiments wherein the electronic device 50 is a Schottky diode of the JBS- or MPS-type, the active area 54 may be defined as the portion of the semiconductor body 53 wherein the JB elements 59 are accommodated.

The electronic device 50 further comprises an anode termination region 62 of conductivity opposite to that of the semiconductor body 53 (i.e. here of the P-type), which extends into the semiconductor body 53, in particular in the drift region 53", into the edge area 55.

The anode termination region 62 may have a high concentration of doping species, for example comprised between 10¹⁷ and 10²¹ atoms/cm³, in particular such as to form a degenerate semiconductor region. In practice, the anode termination region 62 may have, from an electrical point of view, a metal or quasi-metal behavior.

The anode termination region 62 extends into the epitaxial region 53" starting from the front surface 53a, at a distance along the X axis from the barrier doped regions 59'. In particular, the anode termination region 62 extends, along a direction parallel to the X axis, between the barrier doped regions 59' and the lateral surface 53c of the semiconductor body 53.

In the embodiment of Figure 2, the anode termination region 62 extends completely into the edge area 55; in practice, the anode termination region 62 laterally delimits the active area 54.

However, the anode termination region 62 may also extend in part into the active area 54, depending on the specific structure of the electronic device 50.

The anode termination region 62 may have, along the X axis, a greater width than the barrier doped regions 59'; for example, comprised between 10 µm and 100 µm.

The electronic device 50 further comprises an edge termination region, or protection ring, 63.

The edge termination region 63 is formed by a further doped region, here of P-type, extending into the edge area 55 in the drift region 53", at the front surface 53a.

The edge termination region 63 may have a concentration of doping species lower than that of the anode termination region 62, for example comprised between 10¹⁵ and 10¹⁸ atoms/cm³.

In plan view, on an XY plane, the edge termination region 63 extends around the active area 54.

The edge termination region 63 may partially overlie the anode termination region 62.

However, the edge termination region 63 is not essential and may be omitted.

The electronic device 50 further comprises a metal contact region 65 and a (metal) field plate region 72.

The metal contact region 65 extends on the front surface 53a, in contact therewith, both onto the active area 54 and partially onto the anode termination region 62, terminating above the anode termination region 62.

In practice, the metal contact region 65 also partially extends above the edge area 55.

In detail, the metal contact region 65 comprises an interface portion 66, formed by a metal layer 67 for example of titanium, nickel, Mo, TiN, MoN, V, Ta, W, WC, which extends directly on the front surface 53a, and an upper portion 70 for example of AlSiCu, AlCu, Al or more generally Al-based alloys, which extends on the interface portion 66.

The interface portion 66 has a lower thickness than that of the upper portion 70.

The interface portion 66 may have a thickness (measured along the Z axis) comprised for example between 10 nm and 200 nm.

The upper portion 70 has a greater thickness than the interface portion 66, for example comprised between 2 µm and 10 µm. This may ensure a reliable and robust electrical connection of the metal contact region 65.

Overall, the metal contact region 65 may have a thickness, measured along the Z axis, greater than or equal to 2 µm.

The upper portion 70 extends, in a direction parallel to the X axis, from the active area 54 towards the outside of the electronic device 50, i.e. towards the lateral surface 53c, and terminates facing, along the Z axis, the anode termination region 62.

In particular, in the embodiment of Figure 2, the interface portion 66 extends, moving away from the active area 54 in a direction parallel to the X axis, beyond the upper portion 70; this feature, that is optional, may simplify, during manufacturing, obtaining physical and electrical continuity of the metal contact region 65 with the metal field plate region 72.

A plurality of Schottky diodes 71 is formed at the interface between the semiconductor body 53 and the metal contact region 65, laterally and in between the barrier doped regions 59'. In particular, Schottky diodes are formed by semiconductor-metal junctions formed by the portions of the semiconductor body 53 in direct contact with the metal contact region 65.

In practice, the metal contact region 65 forms an anode metallization of the electronic device 50.

Furthermore, the metal contact region 65 is in direct electrical contact also with the JB elements 59; in particular in ohmic contact with the respective ohmic contact regions 59".

The field plate region 72 is of metal material and extends over the edge area 55 at a distance from the front surface 53a along the Z axis.

In the embodiment shown, the field plate region 72 is formed by a raised portion of the metal layer 67, contiguous to the interface portion 66. The fact that the field plate region 72 is formed by the same layer as the metal contact region 65 may simplify the manufacturing of the electronic device 50.

The field plate region 72 has a lower thickness than that of the metal contact region 65. In particular, in this embodiment, the field plate region 72 has the same thickness as the interface portion 66. This thickness allows the region 72 to act effectively as a field plate.

The field plate region 72 is contiguous to the interface portion 66 of the metal layer, and therefore in direct electrical contact with the metal contact region 65.

The field plate region 72 extends, in a direction parallel to the X axis, beyond the anode termination region 62. In particular, in the embodiment of Figure 2, it terminates above the edge termination region 63, facing it at a distance along the Z axis.

The field plate region 72 may extend, in a direction parallel to the X axis, towards the lateral surface 53c, for a width modulable during the design step depending on the specific application.

For example, the field plate region 72 may terminate above (parallel to the Z axis) the edge termination region 63 and the edge termination region 63 may extend toward the lateral surface 53c (parallel to the X axis) beyond with respect to the field plate region 72. In particular, the edge termination region 63 may extend beyond the field plate region 72 by a width, measured along the X axis in the direction of the lateral surface 53c, comprised between 0 µm (i.e. the external border of the field plate region 72 may be aligned with the external border of the edge termination region 63) and 50 µm, depending on the voltage class of the electronic device 50.

The electronic device 50 further comprises a plurality of insulating layers 80, 81, 82, 83.

The insulating layer 80, of electrically insulating or dielectric material (for example silicon oxide or TEOS - tetraethyl orthosilicate), extends, above the edge area 55, directly on the front surface 53a of the semiconductor body 53.

The insulating layer 80 may have a thickness, along the Z axis, comprised for example between 0.1 µm and 5 µm.

In detail, the insulating layer 80 comprises a portion 80A, which extends below the field plate region 72, and separates the field plate region 72 from the front surface 53a, and a portion 80B which extends, in a direction parallel to the X axis, laterally and contiguous to the portion 80A on the edge area 55.

The insulating layer 81, of electrically insulating or dielectric material (for example silicon oxide or TEOS - tetraethyl orthosilicate) extends over the front surface 53a of the semiconductor body 53.

The insulating layer 81 may have a thickness, along the Z axis, comprised for example between 0.01 µm and 5 µm.

In detail, the insulating layer 81 comprises a portion 81A, which extends on the field plate region 72 and on at least part of the metal contact region 65 above the active area 54, and a portion 81B which extends, in a direction parallel to the X axis, laterally and contiguous to the portion 81A on the portion 80B of the insulating layer 80.

Since the insulating layer 81 may be of the same material as the insulating layer 80, it may be indistinguishable from the latter in the overlying zone; the border between the insulating layers 80, 81 is therefore indicated with a dashed line in Figure 2.

The insulating layer 82, also referred to as interface layer, is of an electrically insulating or dielectric material different from the insulating layer 81, for example a nitride or oxynitride, in particular of silicon nitride, or aluminum oxide, hafnium oxide, etc.

The insulating layer 82 may have a thickness comprised for example between 0.01 µm and 5 µm.

The insulating layer 82 extends on the insulating layer 81, in particular conformally on the insulating layer 81.

In this embodiment, the insulating layer 82 also extends in part directly on the upper portion 70 of the metal contact region 65, as well as partially on the front surface 53a, alongside the external peripheral edge of the insulating layers 80, 81.

In detail, the insulating layer 82 comprises a portion 82A, which extends above and facing at a distance along the Z axis the metal regions 65, 72, and a portion 82B which extends laterally and contiguous to the portion 82A onto the portion 81B of the insulating layer 81.

The insulating layer 83, also referred to as passivation layer, is of electrically insulating or dielectric material, in particular an organic material and even more in particular a polymeric material such as for example polymide (for example, PIX).

The insulating layer 83 may have a planarized upper surface.

The insulating layer 83 may have a thickness comprised for example between 1 µm and 20 µm.

The insulating layer 83 comprises portions 83A, 83B which completely cover the insulating layer 82, in particular overlying the respective portions 82A, 82B.

The insulating layer 83 may also extend in part, over the active area 54, directly on the upper portion 70 of the metal contact region 65 and, in part on the edge area 55 directly on the front surface 53a.

In practice, the insulating layer 82 extends between the passivation layer 83 and the underlying insulating layers (80, 81), and favors the adhesion of the overlying passivation layer 83.

One or more further protection insulating layers, not shown here, for example of a resin such as Bakelite, may extend above the passivation layer 83, for packaging the electronic device 50.

In the electronic device 50, the presence of the metal field plate region 72 thinner than the metal contact region 65 allows the risk of cracks in the insulating layers 80-83, in particular in the insulating layer 82, to be reduced.

In fact, the thickness of the field plate region 72 forms a step inside the insulating region formed by the insulating layers 80-83, in particular at the border between the respective portions 81A and 82A which face the metal field plate region 72 and the respective adjacent portions 81B, 82B. The fact that the thickness of the field plate region 72 is lower than that of the metal contact region 65 reduces the height of the step and consequently reduces the risk of cracks.

This risk may be particularly reduced in case the overlying insulating region comprises a nitride layer (e.g., insulating layer 82) that is thin and conformal to the profile of the underlying layers.

The risk of cracks may remain low even following numerous thermal cycles and/or hostile environmental conditions.

The absence of cracks ensures a high electrical robustness of the electronic device 50, in use; in fact, even in the presence of high voltages and possible delaminations in the peripheral portion of the insulating layers 80-83, the metal regions 65, 72 may remain protected from electric discharges which might cause malfunctions or breakages of the electronic device 50.

Furthermore, the anode termination region 62 may at least in part shield the overlying metal contact region 65 from the high electric fields that may generate in the semiconductor body 53 in use, in particular in reverse bias. This contributes to increasing the electrical robustness of the electronic device 50, in use.

This effect may be further favored in case the anode termination region 62 has a high doping level (e.g. comprised between 10¹⁷ and 10²¹ atoms/cm³).

The presence of a triple insulation layer (insulating layers 80-83) further protects the electronic device 50 from the external environment and in particular prevents humidity from reaching the high-voltage structures and metallizations (65, 72).

This protection may be accentuated when the insulating layer 81 encloses and seals the periphery of the metallization 65; the insulating layer 82 encloses and seals the insulating layer 81 both at the top and on its lateral edges; and, in particular also when the insulating layer 83 encloses and seals the insulating layer 82 both at the top and on its lateral edges.

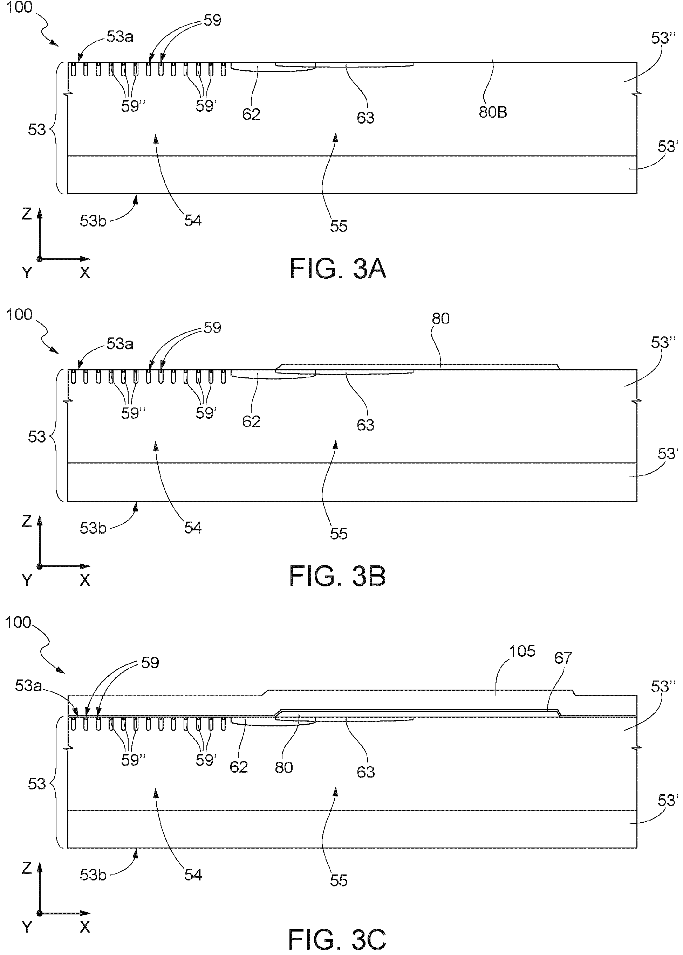

Manufacturing steps of the electronic device 50 are described hereinafter with reference to Figures 3A-3F and limitedly to manufacturing steps useful for understanding the present invention.

With reference to Figure 3A, a wafer 100 has been initially processed so as to form, in the semiconductor body 53 of SiC and in a per se known manner, the JB elements 59, the anode termination region 62 and the edge termination region 63.

Subsequently, Figure 3B, the insulating layer 80 is formed on the front surface 53a.

The insulating layer 80 may be formed through blanket deposition of insulating or dielectric material, for example by CVD (Chemical Vapor Deposition) or LPCVD (Low Pressure Chemical Vapor Deposition), and subsequent patterning (e.g., lithography and etching).

With reference to Figure 3C, the metal layer 67, for example of titanium or nickel, is deposited on the wafer 100, covering the front surface 53a and the insulating layer 80, and an upper metal layer 105 (which will form the upper portion 70 of the metal contact region 65 of Figure 1) is deposited on the metal layer 67.

In detail, the metal layers 67, 105 are deposited, through evaporation or sputtering, in a blanket manner.

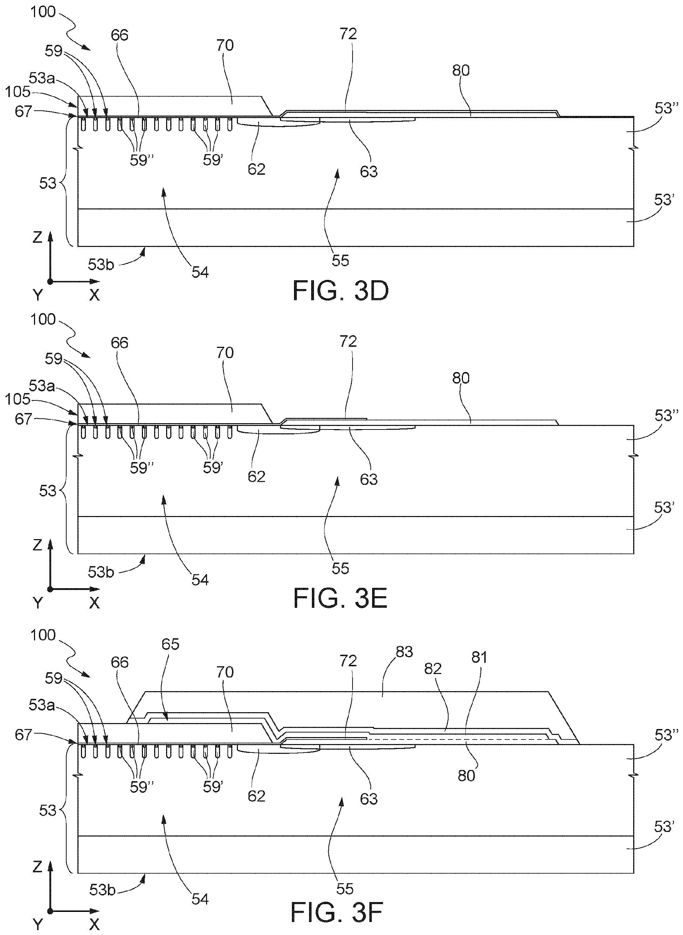

Then, Figure 3D, the upper metal layer 105 is patterned, through lithography and etching steps, in such a way as to form the upper portion 70 of the metal contact region 65 extending above the active area 54 and partially on the anode termination region 62.

Partial removal of the upper metal layer 105 exposes, above the edge area 55, the underlying metal layer 67.

In Figure 3E, the metal layer 67 is patterned, through lithography and etching steps, in such a way as to form the field plate region 72.

Subsequently, Figure 3F, the insulating layers 81, 82, 83 are formed, for example through deposition and subsequent patterning.

The manufacturing process then continues with subsequent steps to form the further elements of the electronic device 50, not described here in detail (for example, to form the ohmic contact layer 56 and the cathode metallization 57) and for dicing the wafer 100, to form the electronic device 50.

The present manufacturing process allows the electronic device 50 to be obtained in a simple and cost-effective manner.

In particular, the fact of forming the field plate region 72 starting from the same metal layer 67 used for the metal contact region 65 allows to easily obtain a metal field plate region thinner than the metal contact region 65.

In fact, maintaining a greater thickness than the metal contact region 65 may facilitate the electrical connection operations (for example through wire bonding) of the electronic device 50.

Finally, it is clear that modifications and variations may be made to the electronic device and manufacturing process thereof described and illustrated herein without thereby departing from the scope of the present invention, as defined in the attached claims.

For example, the insulating region above the front surface 53a may comprise a different number of insulating layers made of material different from each other, in particular two insulating layers (e.g., only the layers 82 and 83) above the metal regions 65, 82. For example, the layer 81 may be absent; in this case the layer 82 (for example of nitride or oxynitride) may extend directly on the metal regions 65, 72 and on the portion 80B of the metal layer 80.

## Claims

1. An electronic device (50) comprising:
a semiconductor body (53) of silicon carbide having a front surface (53a) and a first conductivity type (N), the semiconductor body accommodating an active area (54) and an edge area (55) laterally to the active area along a first direction (X);
a first termination doped region (62) extending from the front surface into the semiconductor body, at least in part within the edge area (55), the first termination doped region having a second conductivity type (P) different from the first conductivity type;
a first metal region (65) extending onto the front surface of the semiconductor body, above the active area (54) and the first termination doped region (62), wherein the first metal region has a first thickness and interrupts, along the first direction (X), above the first termination doped region; and
a second metal region (72) extending at a distance from the front surface (53a) above the edge area (55), laterally to the first metal region (65) along the first direction (X),
wherein the second metal region has a second thickness smaller than the first thickness.

2. The electronic device according to the preceding claim, further comprising an insulating region (80, 81, 82, 83) having a first portion (81A, 82A, 83A) extending on the first metal region (65) and the second metal region (72), and a second portion (80B, 81B, 82B, 83B) extending on the front surface (53a) laterally to the first portion along the first direction (X) and above the edge area (55).

3. The electronic device according to claim 1 or 2, wherein the first metal region (65) has a thickness greater than or equal to 2 µm.

4. The electronic device according to any of the preceding claims, wherein the second metal region (72) has a thickness comprised between 10 nm and 200 nm.

5. The electronic device according to any of the preceding claims, wherein the second metal region (72) is in electrical contact with the first metal region.

6. The electronic device according to any of the preceding claims, wherein the first metal region (65) comprises a first metal layer (66) and a second metal layer (70) on the first metal layer, and the second metal region (72) comprises a third metal layer (67) contiguous to the first metal layer and of the same material as the first metal layer.

7. The electronic device according to any of the preceding claims, wherein the first termination doped region (62) has a doping level greater than 10¹⁷ atoms/cm³.

8. The electronic device according to any of the preceding claims, wherein the electronic device is a Schottky diode, in particular of the JBS- or MPS-type.

9. The electronic device according to any of the preceding claims, wherein the first metal region (65) is, in the active area (54), in Schottky contact with the semiconductor body.

10. The electronic device according to any of the preceding claims, further comprising a plurality of barrier doped regions (59') extending into the active area (54) of the semiconductor body starting from the front surface (53a), at a distance from each other along the first direction (X), the barrier doped regions having the second conductivity type (P).

11. A method of manufacturing an electronic device (50) comprising, starting from a semiconductor body (53) of silicon carbide having a front surface (53a) and a first conductivity type (N), wherein the semiconductor body accommodates an active area (54) and an edge area (55) laterally to the active area along a first direction (X):
forming a first termination doped region (62) extending from the front surface into the semiconductor body, at least in part within the edge area (55), the first termination doped region having a second conductivity type (P) different from the first conductivity type;
forming a first metal region (65) extending on the front surface of the semiconductor body, above the active area (54) and the first termination doped region (62), wherein the first metal region has a first thickness and interrupts, along the first direction (X), above the first termination doped region; and
forming a second metal region (72) extending at a distance from the front surface (53a) above the edge area (55), laterally to the first metal region (65) along the first direction (X),
wherein the second metal region has a second thickness smaller than the first thickness.

12. The manufacturing method according to the preceding claim, wherein forming a first metal region (65) comprises:
depositing a first metal layer (67) on the front surface (53a) of the semiconductor body (53); and
depositing, on the first metal layer, a second metal layer (105) having a thickness greater than the first metal layer.

13. The manufacturing method according to the preceding claim, wherein the second metal region (72) is formed by a portion of the first metal layer (67), through patterning of the first metal layer.

14. The manufacturing method according to claim 12 or 13, wherein forming a second metal region (72) comprises:
forming a first insulating layer (80) on the front surface (53a), before depositing the first metal layer; and
depositing the first metal layer (67) also on a portion (80B) of the first insulating layer (80).

15. The manufacturing method according to any of claims 12-14, wherein forming the first metal region and the second metal region comprises:
performing a blanket deposition of the first metal layer;
performing a blanket deposition of the second metal layer on the first metal layer;
etching the second metal layer; and
etching the first metal layer after etching the second metal layer,
so as that the first metal region comprises a first portion (66) of the first metal layer (67) extending on the front surface (53a) and a portion (70) of the second metal layer (105) extending on the first portion of the first metal layer, and so as that the second metal region comprises a second portion (72) of the first metal layer extending at a distance from the front surface (53a).
